# FASCICULE DE BREVET EUROPEEN

(11) **EP 1 192 592 B1**
(45) Date de publication et mention de la délivrance du brevet: **23.04.2003**
(21) Numéro de dépôt: 00938859.6
(22) Date de dépôt: 30.05.2000
(51) Int. Cl.: G06K 19/077

(54) **DISPOSITIF ET PROCEDE DE FABRICATION DE DISPOSITIFS ELECTRONIQUES COMPORTANT AU MOINS UNE PUCE FIXEE SUR UN SUPPORT**
VORRICHTUNG UND HESTELLUNGSVERFAHREN VON VORRICHTUNGEN MIT ZUMINDEST EINER IC AU
DEVICE AND METHOD FOR MAKING DEVICES COMPRISING AT LEAST A CHIP FIXED ON A SUPPORT

(30) Priorité: 15.06.1999 FR 9907551
(43) Date de publication de la demande: 03.04.2002
(73) Titulaire: Gemplus, 13881 Gémenos Cedex (FR)
(72) Inventeur: CALVAS, Bernard, 13011 Marseille (FR); FIDALGO, Jean-Christophe, 13420 Gémenos (FR); PATRICE, Philippe, 13011 MARSEILLE (FR)
(86) Numéro de dépôt international: FR0001490
(87) Numéro de publication internationale: WO00077729

(56) Documents cités:
- EP-A- 0 810 547
- WO-A-98/02921
- DE-A- 4 431 606

## Description

L'invention concerne un dispositif électronique avec une puce pourvue de plots et une plage d'interconnexion en surépaisseur d'un support, où notamment l'interconnexion est réalisée par soudure à travers les plots ou le support.

Dans certains domaines, dont celui des cartes à puce, il est nécessaire de réaliser le montage d'un microcircuit ou puce sur un support relativement mince et flexible. Dans le cas des cartes à puce, il est nécessaire d'une part que la présence de la puce n'occasionne pas une sur épaisseur au-delà d'un seuil établit par des normes internationales (actuellement fixée à 50 µm) et d'autre part que le montage de la puce soit suffisamment sûr pour permettre une utilisation durable même lorsque la carte est soumise à des contraintes de pliage et de torsion relativement élevées.

De manière classique, on évite de créer une sur épaisseur trop importante en logeant la puce dans une cavité ménagée à cet effet dans l'épaisseur du support.

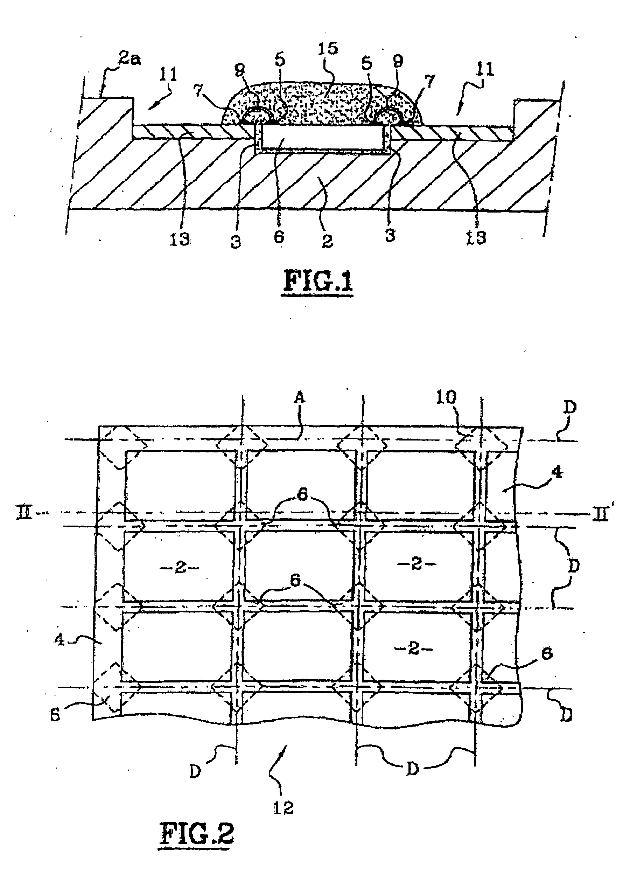

La figure 1 montre schématiquement un montage d'une puce 6 sur un support 2 destiné à constituer une carte à puce. La puce 6 est logée presque intégralement dans une cavité 3 de manière à ce que son épaisseur soit comprise dans celle du support 2. La puce 6 présente un ensemble de plots de connexion 5 sur les bords de sa surface tournée vers l'extérieur. Ces plots 5 sont reliés à des contacts respectifs 7 du support par des fils 9. Les contacts 7 peuvent être situés au fond de la cavité, ou à un niveau intermédiaire dans une zone de renfoncement 11 autour de la cavité, comme dans l'exemple illustré. Ces contacts 7 sont à leur tour reliés électriquement à des plages de contact 13 destinées à permettre une connexion ohmique avec un lecteur de cartes. Ces plages de contact 13 sont logées intégralement dans le renfoncement 11 afin que leur épaisseur soit aussi contenue dans celle du support 2.

Pour protéger l'ensemble, on forme un enrobage de matériau protecteur 15 recouvrant toute la zone occupée par la cavité 3, les fils 9 et une portion des bords internes des plages de contact 11.

Cette technique souffre de plusieurs inconvénients. Premièrement, l'opération consistant à relier électriquement les plots de connexion 5 de la puce 6 aux contacts 7 nécessite l'utilisation de fils 9 très fins et déllcats formant ainsi des points de fragilité. Qui plus est, les opérations de soudage de ces fils 9 nécessitent un outillage important et un temps non négligeable.

Par ailleurs, la formation de la cavité 3 demande une étape d'usinage qui est à la fois coûteuse et fragilise la carte.

On remarque aussi que cette technique basée sur l'intégration d'une puce dans une cavité d'un support est difficilement exploitable lorsqu'il est nécessaire de rassembler plusieurs composants, par exemple plusieurs puces ou autres éléments passifs ou actifs sur un même support.

De plus, il est Important de concevoir des procédés compatibles avec les outillages automatisés de fabrication en très grande série, autorisant des cadences élevées de report et de soudage de puce.

Au vu de ces problèmes, l'invention propose un procédé et un dispositif selon les revendications.

L'invention met par exemple en oeuvre la technologie des puces réalisées en substrat très mince, telle que décrite dans le document W0-A-9802921 au nom de la société KOPIN. Cette technologie permet notamment de disposer de puces ayant une épaisseur égale à 10 µ, voire très sensiblement inférieure à cette épaisseur.

Dans cet exemple, la plage d'interconnexion du support est réalisée sur une portion de surface d'une face du support se situant dans la plan général de cette face. Autrement dit, on ne crée pas de cavité ou de renfoncement pour accommoder l'épaisseur de cette plage d'interconnexion. De ce fait, la plage d'interconnexion et aussi la puce sont en surépaisseur par rapport au plan général de la face à laquelle elles se situent.

Citons des documents à rapprocher de l'invention.

Le document WO-A-9802921 Kopin déjà évoqué, décrit la fabrication de circuits intégrés hautement flexibles qui peuvent tolérer les flexion, tensions et compressions en maintenant l'intégrité du circuit. Ce circuit est transféré lors de sa fabrication, depuis un second substrat vers un substrat final, qui est appelé "substrat protecteur" dans la demande de brevet.

Le document DE-A-4431606 Siemens décrit un simple module pour carte à puce avec une antenne et un évidemment où est insérée la puce.

Le document EP0810547 G&D décrit une carte où la puce est intégrée dans une cavité.

L'invention sera mieux comprise et ses avantages ressortiront plus clairement à la lecture des modes de réalisation préférés, donnés purement à titre d'exemples non-limitatifs, en référence aux dessins annexés dans lesquels :
- la figure 1 est une vue en coupe d'une carte à puce connue montrant l'emplacement d'une puce dans une cavité du support ;
- la figure 2 est un vue partielle en plan d'une plaquette issue de la technologie dite silicium sur isolant mise en oeuvre dans les modes de réalisation de l'invention ;
- la figure 3 est un vue en coupe d'un ensemble composé d'une puce très mince, d'un substrat protecteur et de plots adhésifs selon la technologie dite de silicium sur isolant ;
- la figure 4 est une vue en coupe schématique montrant l'opération de report de la puce illustrée à la figure 3 sur son support selon un premier mode de réalisation de l'invention ; et
- les figures 5a à 5c sont des vues en coupe schématiques montrant des opérations successives de préparation d'une plaquette comportant des puces très minces réalisées selon la technologie dite de silicium sur isolant et de report de ces puces sur un support selon un deuxième mode de réalisation de l'invention.

La figure 2 est une vue qui montre une plaquette 12 issue de la technologie dite silicium sur isolant (en anglais SOI pour "silicon on insulator"). Cette technologie permet de réaliser des puces 2 - c'est-à-dire la partie active du microcircuit - d'une très grande minceur.

La technologie SOI décrite notamment dans le document WO-A-98 02921 ne seront pas répétés par souci de concision.

Les puces 2 sont disposées en lignes de rangées sur un substrat protecteur isolant 4, typiquement du verre, qui constitue le corps de la plaquette. Ce substrat isolant 4 sert entre autres à protéger les puces 4 qui sont souples en raison de leur minceur (de l'ordre de 10 µ).

Chaque puce 2 est retenue sur le substrat protecteur de verre 4 par des plots adhésifs 6. Ces plots adhésifs 6 sont constitués par des petites aires rectangulaires, tournées à 45° par rapport aux côtés des puces 2 et placées sur les coins respectifs de chaque puce, de sorte qu'en dehors de la périphérie de la plaquette 12 un plot 6 recouvre quatre coins réunis de quatre puces différentes.

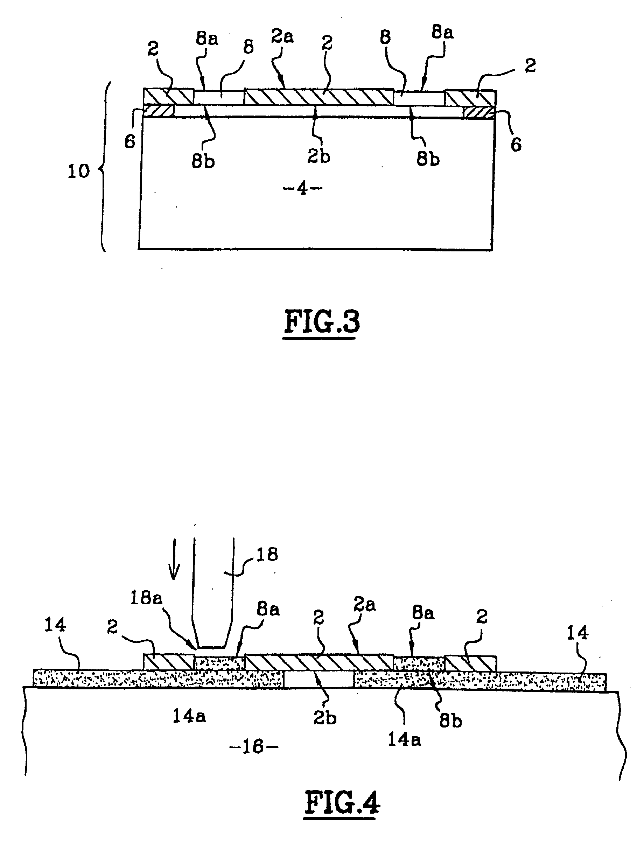

La figure 3 montre un ensemble 10 après découpage de la plaquette 12 en surfaces élémentaires comprenant chacune une puce 2. L'ensemble 10 comprend ainsi la puce elle-même 2, son substrat protecteur 4 aux dimensions de la puce, et les plots adhésifs 6 retenant la puce au substrat par ses coins.

La puce 2 est dotée de plots d'interconnexion 8 qui permettent de communiquer entre le circuit qu'elle contient et l'environnement extérieur du circuit, notamment en ce qui concerne les signaux d'entrée et de sortie et une tension d'alimentation.

Ces plots 8 sont réalisés par des aires en matériau conducteur, en l'occurrence l'aluminium. Du fait de la grande minceur de la puce 2 - son épaisseur n'excède pas 100 µ et est dans l'exemple de l'ordre de 5 µ - il est possible de réaliser les plots d'interconnexion de manière à ce qu'ils présentent une surface de contact à chaque face 2a et 2b de la puce 2. Autrement dit, chaque plot d'interconnexion traverse l'épaisseur de la puce 2, comme le montre la figure 3.

Dans l'exemple illustré, les faces de contact 8a et 8b des plots d'interconnexion affleurent sensiblement les faces respectives 2a et 2b de la puce 2. Toutefois, ces faces de contact 8a et 8b peuvent être légèrement en retrait ou en saillie vis-à-vis de ces faces respectives 2a et 2b tout en étant considéré comme situées sensiblement sur le plan général de la face correspondant 2a, 2b de la puce. Ces plots de connexion se distinguent de ceux connus sous forme de bossages (appelés également "bumps" dans la terminologie anglo-saxonne) qui présentent une nette protubérance vis-à-vis du plan de la puce, cette protubérance étant précisément exploitée pour créer l'interconnexion.

Le substrat protecteur 4 et les plots adhésifs 6 servent essentiellement à protéger la puce lors de la fabrication et des manipulations avant le report de la puce sur son support définitif.

La figure 4 montre une étape de report de puce 2 après le retrait du substrat protecteur 4 et des plots adhésifs 6. Dans cette réalisation, le retrait du substrat protecteur s'effectue par une opération de pelage de cette dernière avant l'étape fixation définitive de la puce.

La puce nue 2 est alors reportée sur son interface de communication 14 réalisée à la surface de son support 16. Cette interface de communication 14 peut, selon les applications envisagées, servir à :
- relier des entrées et sorties de la puce avec l'extérieur, notamment les lecteurs de cartes à contact; et/ou
- assurer les interconnexions nécessaires entre la puce et des éléments réalisés au niveau du support. Ces éléments peuvent être une antenne intégrée au support 2 de manière à constituer une carte dite "carte sans contact", connue en elle-même, d'autres éléments de circuit intégrés à la carte (par exemple une ou plusieurs autres puces), ou encore une source d'alimentation électrique.

Dans le mode de réalisation, l'interface de communication 14 est matérialisée par des métallisations destinées à assurer différentes liaisons électriques entre la puce et des éléments associés au support 16. Ces métallisations convergent vers l'emplacement du support destiné à recevoir la puce 2 en présentant des plages de connexion 14a. Chaque plage de connexion 14a de l'interface de communication est située à l'aplomb d'un plot de contact respectif 8 de la puce 2. Au moins la partie de l'interface de communication qui comprend les plages de connexion 14a est réalisée en aluminium.

Une fois la puce positionnée vis-à-vis des plages de connexion 14a, on effectue une soudure pour solidariser ces dernières avec les plots respectifs 8 de la puce. On remarque que les plots de contact 8 sont traversants ; la puce peut être reportée sur son support 16 avec l'une ou l'autre de ses faces 2a ou 2b tournée vers ce dernier. Dans l'exemple, les faces 8b des plots de contact sont en face des plages de connexion 14a.

La soudure est réalisée au moyen d'un outil de thermo compression qui applique un pression sur la face 8a du plot de contact opposée à celle 8b tournée vers la plage de connexion 14a. A cette fin, l'outil de thermo compression présente une tête de soudure 18a ayant une section sensiblement égale ou inférieure à la surface du plot de contact 8, destinée à venir contre la surface 8a de ce dernier et presser le plot contre sa plage de connexion 14a correspondante. En même temps, l'outil 18 fournit une énergie thermique en engendrant des vibrations à travers le plot 8. Cette énergie élève la température au point de contact et engendre la fusion du plot de contact 8 avec sa plage de connexion 14a. On note que ces deux éléments de connexion 8 et 14a, étant tous les deux en aluminium, sont parfaitement compatibles avec cette technique de thermo compression.

La technique connue de thermo compression en elle-même n'est pas détaillée ici par souci de concision.

En variante, il est également envisageable de réaliser la soudure des points de connexion 8 et 14a par ultrasons ou par faisceau laser selon de techniques connues en elles-mêmes. Dans ces cas aussi, l'énergie de soudure peut être appliquée sur la face 8a du plot 8 à l'opposée de celle 8b en contact avec la plage de connexion et ainsi traverser l'épaisseur du plot.

Bien entendu, il est possible d'envisager de réaliser les plots de contact 8 et/ou les plages de connexion 14a en d'autres métaux ou alliages dès lors qu'ils sont compatibles avec les techniques de fabrication et la soudure utilisées.

L'utilisation de plots de contact 8 sensiblement sans relief par rapport aux faces 2a et 2b respectives du substrat, c'est-à-dire sans bossage, permet notamment de réaliser des soudures automatisées selon la technique de "soudure automatisée sur bande sans bossage", également connue sous le terme anglo-saxon de "bumpless tape automatic bonding" ou "bumpless TAB". Cette technique permet de réaliser des soudure à des cadences très élevées en montant les puces 2 sur une bande que l'on fait défiler devant l'outil de soudure 18, les supports 16 étant également mis en défilement en synchronisme avec le rythme des soudures.

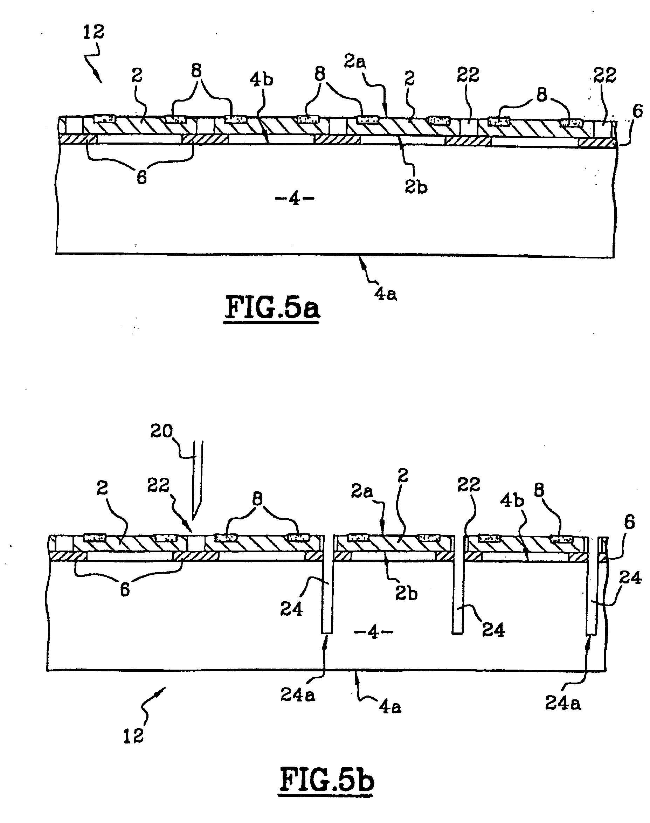

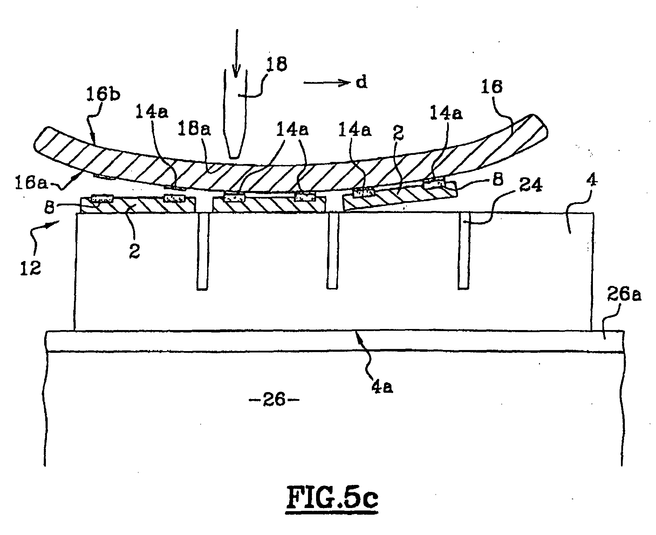

Sur la figure 5 une deuxième réalisation permet de souder des puces très minces et pourvues de plots de contact sans bossage. Ces puces ont en grande partie les mêmes caractéristiques que celles décrites. Aussi, seules les différences seront décrites ici par souci de concision.

Comme le montre la figure 5a, les puces 2 sont munies de plots de connexion 8 qui ne présentent qu'une surface de contact, présente sur la face 2a tournée vers l'extérieur vis-à-vis du substrat protecteur en verre 4. Ces plots de contact ne présentent sensiblement pas de relief relativement à la face 2a sur laquelle ils sont présents, étant réalisés selon la technologie dite sans bossage ou "bumpless" selon le terme anglo-saxon. Dans l'exemple, les plots 8 sont réalisés aussi en aluminium, bien que d'autres matériaux électriquement conducteurs peuvent être envisagés selon la compatibilité avec la technique de soudure prévue.

Conformément à la deuxième réalisation, on pratique une découpe de l'ensemble 10 comportant la puce 2, les plots adhésifs 6 et une partie de l'épaisseur du substrat 4. Cette découpe partielle est réalisée par un outil de découpe 20, tel qu'une lame rotative, qui pratique à chaque espace 22 séparant deux puces 2 adjacentes, une entaille 24 perpendiculaire au plan général de la plaquette 12. Chaque entaille 24 traverse un plot adhésif 6 (et éventuellement une portion du bord inutilisé de la puce 2) et une partie du substrat protecteur en verre 4. Le point de terminaison 24a de chaque entaille n'est pas critique, dès lors qu'il se situe au moins sous le niveau de la surface inférieure 2b des puces et au dessus de la face 4a du substrat opposée à celle 4b en regard des puces 2.

On notera que les entailles 24 sont pratiquées sur un quadrillage qui divise les puces 2 en lignes et en rangs sur la plaquette 12 (figure 2). Ainsi, chacun des quatre bords d'une puce 2 est entouré par une entaille 24.

Une fois les entailles 24 réalisées, on pose la face 4a de la plaquette 12 sur une plate-forme 26 de manière à ce que la plaquette y soit maintenue fixe. Cette fixation peut être obtenue par des moyens d'amarrage mécaniques de la plaquette et/ou par interposition d'un adhésif entre la plate-forme 26 et la face 4a du substrat de verre 4. A titre d'exemple, la plate-forme 26 peut être dotée sur sa face supérieure (qui reçoit la plaquette 12) d'un film adhésif 26a (figure 5c). L'ensemble comportant la plaquette 12 avec les entailles 24 est alors prêt pour une opération de report des puces sur le support auquel les puces sont destinées (film, carte, circuit imprimé, grille, etc.).

Dans l'exemple, le support 16 est le même que pour le cas du premier mode de réalisation. Comme le montre la figure 5c, ce support comporte également des métallisations formées en surface dont les extrémités convergent pour former des plages de connexion 14a en aluminium ou autre matériau compatible avec la technique de soudure utilisée, chaque plage de connexion étant destinée à être solidarisée avec un plot correspondant 8 de la puce 2.

Le support 16 tel que représenté est sous forme de bande continue qui sera découpée en dispositifs individuels (par exemple des cartes à puce) une fois l'opération de soudure terminée.

Pour réaliser la soudure entre les plots 8 des puces 2 et les plages de connexion correspondantes 12 des support, on utilise un outil de thermo compression 18 tel que décrit précédemment dans le cadre du premier mode de réalisation.

Chaque plot 8 d'une puce 2 est mis en correspondance avec sa plage de connexion correspondante 14a sous la tête 18a de l'outil de thermo compression. Cet agencement est obtenu par défilement sous celle-ci de la bande formant le support 16 dans le sens de la flèche d et le déplacement en corrélation de la plate-forme 26 qui maintient la plaquette 12. La tête 18a de l'outil de thermo compression 18 est située juste au dessus de la face 16b du support opposée à celle 16a destinée à recevoir une puce 2.

Comme le montre la figure 5c, la bande formant le support 16 suit une trajectoire curviligne et affleure la plaquette 12 au point où cette dernière se situe à une tangente, à l'aplomb de l'outil de thermo compression. A ce point, un plot 8 de la puce se trouve en face de la plage de connexion 14a correspondante formée sur le support 16. L'outil de thermo compression 18 effectue alors le soudage du plot 8 avec la plage de connexion 14a en appliquant de l'énergie à travers l'épaisseur du support 16 et du plot 8.

Pour chaque puce 2 ainsi soudée sur son support, la trajectoire de la bande l'éloigne de son substrat protecteur 4. Il se crée alors une force d'arrachement ou de clivage de la puce 2 de son substrat protecteur 4. Ce dernier, en vertu de fait qu'il soit maintenu sur sa plate-forme, permet à la puce de se désolidariser des plots adhésifs 6 lors de son éloignement du substrat. En effet, l'adhérence entre les plots 8 et les plages de connexion 14a est sensiblement plus élevée que celle des plots adhésifs 6. De même, l'adhérence des plots adhésifs 6 est sensiblement inférieure à la résistance à la rupture du substrat 4, même fragilisé par les entailles 24. On notera que lorsque la puce 2 est désolidarisée de son substrat protecteur 4, les plots adhésifs 6 restent sur ce dernier.

On comprendra que les entailles 24 servent essentiellement à départager les bords autour de chaque puce 2. Le fait qu'elles entament partiellement l'épaisseur du substrat protecteur 4 n'a pas un rôle décisif dans le processus de soudure qui vient d'être décrit. En effet, l'épaisseur du substrat protecteur 4 est partiellement entamée seulement du fait que les techniques actuelles de découpe ne permettent pas de limiter exactement la profondeur de la découpe à l'épaisseur de la puce, laquelle peut être sensiblement inférieure à 10 µ. Aussi, l'entaille dans l'épaisseur du substrat est due à la tolérance dans la précision de l'outil de découpe 20.

Selon une variante de la deuxième réalisation, on scie totalement la plaquette 12 aux emplacements des entailles 24, de manière à ce que chaque portion de substrat protecteur 4 autour d'une puce 2 soit mécaniquement désolidarisée du reste de la plaquette 12. L'ensemble ainsi découpé est maintenu dans sa configuration avant découpage par le film adhésif 26a. Dans cette variante, la force de clivage occasionnée par le retrait du support 16 avec les puces 2 soudées est entièrement contrée, au niveau de substrat protecteur 4, par la force adhésive du film 26a.

Bien entendu, le deuxième mode de réalisation et sa variante permettent également d'utiliser d'autres techniques de soudage, telles que le soudage par ultrasons, par faisceau laser, etc.

Pour les premier et deuxième modes de réalisation, on peut prévoir une étape ultérieure de dépôt de couche protectrice sur au moins les parties exposées de la ou chaque puce sur son support. Ce dépôt peut être réalisé par report d'une fine pellicule ou par pulvérisation d'un vernis.

Bien entendu, le domaine de l'invention s'étend à toutes les applications nécessitant un report de puce très mince sur en surface d'un support, celui-ci pouvant être non seulement souple (film, feuille, carte plastique, etc.) mais aussi rigide.

## Revendications

1. Procédé de fabrication d'un dispositif électronique comportant au moins une puce (2) et un support (16) ; ce procédé comportant les étapes de : a) prévoir une puce (2) ayant une épaisseur n'excédant pas 100µm et présentant au moins un plot de contact (8) en matériau soudable ; b) prévoir un support (16) ayant au moins une interface de communication (14) avec au moins une plage d'interconnexion (14a), la plage d'interconnexion (14a) étant en surépaisseur dans le plan général du support qui est sans cavité ou renfoncement pour accommoder cette plage (14a) ; c) reporter la puce (2) en plaçant le plot en regard de la plage d'interconnexion afin que cette plage soit entre la puce et le support ; puis d) souder le plot de contact (8) avec la plage d'interconnexion correspondante du support (16).

2. Procédé selon la revendication 1, **caractérisé par** les étapes qui : prévoient (b) que soit le support (16) est dans un matériau compatible avec la technique de soudure utilisée, pour appliquer l'énergie de soudage à travers l'épaisseur de ce support (16) ; soit le plot de contact (8) traverse l'épaisseur de la puce (2) pour présenter une surface de soudure (8a ; 8b) sur chacune des faces (2a; 2b) ; et après le report c) de la puce (2) à la surface du suoport (16) : réalisent la soudure d) du plot de contact (8) avec la plage d'interconnexion (14a) correspondante du support (16), en appliquant l'énergie de soudage à travers l'épaisseur du support (16) ou du plot traversant (8).

3. Procédé selon la revendication 1 ou 2, **caractérisé en ce que** la puce (2) est retenue par une face (2a ; 2b) sur un substrat protecteur (4), l'étape c) de report et / ou l'étape d) de soudure est effectuée avant une étape de retrait de ce substrat protecteur (4).

4. Procédé selon l'une des revendications 1 à 3, **caractérisé en ce que** : à l'étape a) est prévu avec la puce mince (2) un substrat protecteur (4) ayant une première face (4b) qui retient un ensemble de puces (2) ; et avant l'étape d) de soudure sont effectuées dans le substrat protecteur (4) des découpes (24) autour de la puce (2), un point de terminaison (24a) de la profondeur de l'entaille (24) du substrat protecteur (4) se situant au moins sous le niveau d'une face inférieure (2b) de la puce (2) et par exemple au dessus d'une face (4a) de ce substrat protecteur (4) opposée à celle (4b) en regard des puces (2).

5. Procédé selon les revendications 3 et 4, **caractérisé en ce qu'**après l'étape d) de soudure, le support (16) avec sa puce (2) soudée est séparé du substrat protecteur (4), par exemple chaque puce (2) soudée et son support (16) en bande est éloigné du substrat protecteur (4) en créant une force d'arrachement ou de clivage lors de cette étape de retrait.

6. Procédé selon l'une des revendications 4 ou 5, **caractérisé en ce que** le substrat protecteur (4) est retenu de manière à permettre le retrait de la puce (2) par pelage ; par exemple une fois les entailles (24) réalisées, le substrat protecteur (4) est posé sur une plate forme (26) de maintien fixe par amarrage mécanique et / ou interposition d'adhésif (26a) tel que film (26a).

7. Procédé selon l'une des revendications 4 à 6, **caractérisé en ce que** les découpes traversent totalement l'épaisseur du substrat protecteur (4).

8. Procédé selon l'une des revendications 1 à 7, **caractérisé en ce que** le plot de contact (8) traverse l'épaisseur de la puce (2) pour présenter une surface de soudure (8a ; 8b) sur chacune des faces (2a; 2b), et la puce (2) est soudée à la plage d'interconnexion (14a) en appliquant l'énergie de soudage à travers l'épaisseur du plot traversant (8).

9. Procédé selon la revendication 8, **caractérisé en ce que** l'étape d) de soudure est réalisée par thermo compression, ultrasons ou faisceau laser, à travers l'épaisseur du plot traversant (8).

10. Procédé selon la revendication 1 à 7, **caractérisé en ce que** l'étape d) de soudure est réalisée par thermo compression, ultrasons ou faisceau laser, à travers l'épaisseur du support (16) en matériau compatible avec la technique de soudure utilisée.

11. Procédé selon l'une des revendications 1 à 10, **caractérisé par** une étape ultérieure à celle de soudage d) et le cas échéant de retrait d'un substrat protecteur (4), de dépôt d'une couche mince de protection sur au moins les parties exposées de la puce (2) et de son support (16), par report d'une fine pellicule ou pulvérisation de vernis.

12. Dispositif électronique tel que carte à puce ou carte sans contact, comportant au moins une puce (2) et un support (16) ; cette puce (2) comportant au moins un plot de contact (8) en matériau soudable ; le support (16) présentant au moins une interface de communication (14) soudée au plot de contact (8) ; **caractérisé en ce que** l'épaisseur de la puce (2) entre ses faces (2a; 2b) n'excède pas 100 µm ; le support (16) a au moins une plage d'interconnexion (14a) en surépaisseur dans le plan général du support (16) qui est sans cavité ou renfoncement pour accommoder cette plage (14a) ; et la puce (2) est située sur la plage d'interconnexion (14a) afin que cette plage soit entre la puce (2) et son support (16).

13. Dispositif selon la revendication 12, **caractérisé en ce que** soit un support (16) dans un matériau compatible avec l'application de l'énergie de soudage à travers l'épaisseur de ce support (16), soit un plot de contact (8) qui traverse l'épaisseur de la puce (2) pour présenter une surface de soudure (8a ; 8b) sur chacune des faces (2a; 2b), est employé.

14. Dispositif selon la revendication 13, **caractérisé en ce que** la surface de soudure du plot de contact (8) est sensiblement sur le même plan que la face (2b) de la puce (2) en regard de la plage d'interconnexion (14a).

15. Dispositif selon l'une des revendications 12 à 14, **caractérisé en ce que** la puce (2) présente une sur épaisseur égale ou inférieure à 50 µm, relativement au plan général de la face (16a) du support (16) sur laquelle elle (2) est reportée.

16. Dispositif selon l'une des revendications 12 à 15, **caractérisé en ce que** la plage d'interconnexion (14a) est reliée à au moins un élément de l'interface (14) d'entrée et sortie avec un lecteur à contact et / ou d'antenne, à la surface du support (16).

## Patentansprüche

1. Herstellungsverfahren einer elektronischen Vorrichtung mit zumindest einem Chip (2) und einem Träger (16); wobei dieses Verfahren folgende Stufen umfasst: a) einen Chip (2) mit einer Stärke von maximal 100 µm und wenigstens einem Kontaktplot (8) aus schweißbarem Material vorsehen; b) einen Träger (16) mit wenigstens einer Kommunikationsschnittfläche (14) mit wenigstens einem Verbindungsbereich (14a) vorsehen, wobei der Verbindungsbereich (14a) eine Überdicke in der allgemeinen Ebene des Trägers hat, die ohne Aushöhlung oder Ausnehmung ist, um diesen Bereich (14a) anzupassen; c) den Chip (2) durch Platzieren des Plots gegenüber dem Verbindungsbereich übertragen, damit dieser Bereich sich zwischen dem Chip und dem Träger befindet; dann d) den Kontaktplot (8) mit dem entsprechenden Verbindungsbereich des Trägers (16) verschweißen.

2. Verfahren gemäß Anspruch 1, **gekennzeichnet durch** folgende Stufen: in b) vorsehen, dass der Träger (16) in einem mit der eingesetzten Schweißtechnik kompatiblen Material ist, um die Schweißenergie **durch** die Stärke dieses Trägers (16) anzuwenden; das heißt, der Kontaktplot (8) durchquert die Stärke des Chips (2), um auf jeder Seite (2a; 2b) eine Schweißfläche (8a; 8b) aufzuweisen; und nach dem Übertragen (c) des Chips (2) auf die Fläche des Trägers (16): Realisierung des Schweißens (d) des Kontaktplots (8) mit dem entsprechenden Verbindungsbereich (14a) des Trägers (16) **durch** Anwenden der Schweißenergie **durch** die Stärke des Trägers (16) oder des durchquerenden Plots (8).

3. Verfahren gemäß Anspruch 1 oder 2, **dadurch gekennzeichnet, dass** der Chip (2) durch eine Seite (2a; 2b) auf einem Schutzsubstrat (4) festgehalten wird, die Übertragungsstufe d) und / oder die Schweißstufe d) vor einer Abnahmestufe dieses Schutzsubstrats (4) durchgeführt wird.

4. Verfahren gemäß Anspruch 1 bis 3, **dadurch gekennzeichnet, dass**: in der Stufe a) mit dem dünnen Chip (2) ein Schutzsubstrat (4) mit einer ersten Seite (4b) vorgesehen ist, die eine Chipanordnung (2) hält; und vor der Schweißstufe d) im Schutzsubstrat (4) Ausschnitte (24) um den Chip (2) durchgeführt werden, wobei ein Endpunkt (24a) der Tiefe der Kerbe (24) des Schutzsubstrats (4) sich wenigstens unterhalb einer unteren Seite (2b) des Chips (2) und zum Beispiel oberhalb einer Seite (4a) dieses Schutzsubstrats (4) gegenüber derjenigen (4b) gegenüber den Chips (2) befindet.

5. Verfahren gemäß Anspruch 3 und 4, **dadurch gekennzeichnet, dass** die Schweißstufe d), der Träger (16) mit seinem aufgeschweißten Chip (2) vom Schutzsubstrat (4) getrennt wird, zum Beispiel wird jeder aufgeschweißte Chip (2) und sein Träger (16) als Band durch Hervorrufen einer Abreiß- oder Abtrennkraft bei dieser Abnahmestufe vom Schutzsubstrat (4) entfernt.

6. Verfahren gemäß Anspruch 4 oder 5, **dadurch gekennzeichnet, dass** dieses Schutzsubstrat (4) derart festgehalten wird, dass das Abnehmen des Chips (2) durch Abziehen ermöglicht wird; zum Beispiel wird das Schutzsubstrat (4) nach der Realisierung der Kerben (24) auf eine Plattform (26) zur festen Befestigung durch mechanisches Ankoppeln und / oder anhaftendes Zwischenschieben (26a) wie zum Beispiel eines Films (26a) gesetzt.

7. Verfahren gemäß Anspruch 4 bis 6, **dadurch gekennzeichnet, dass** die Ausschnitte die Stärke des Schutzsubstrats (4) vollständig durchqueren.

8. Verfahren gemäß Anspruch 1 bis 7, **dadurch gekennzeichnet, dass** der Kontaktplot (8) die Stärke des Chips (2) durchquert, um eine Schweißfläche (8a; 8b) auf jeder der Seiten (2a; 2b) aufzuweisen, und der Chip (2) wird durch Anwenden der Schweißenergie durch die Stärke des durchquerenden Plots (8) auf den Verbindungsbereich (14a) geschweißt.

9. Verfahren gemäß Anspruch 8, **dadurch gekennzeichnet, dass** die Schweißstufe d) durch Thermokompression, Ultraschall oder Laserstrahl durch die Stärke des durchquerenden Plots (8) realisiert wird.

10. Verfahren gemäß Anspruch 1 bis 7, **dadurch gekennzeichnet, dass** die Schweißstufe d) durch Thermokompression, Ultraschall oder Laser durch die Stärke des Trägers (16) aus mit der eingesetzten Schweißtechnik kompatiblem Material realisiert wird.

11. Verfahren gemäß Anspruch 1 bis 10, **gekennzeichnet durch** eine der Schweißstufe d) nachfolgende Stufe und gegebenenfalls der Abnahme des Schutzsubstrats (4), des Aufbringens einer dünnen Schutzschicht auf wenigstens den freiliegenden Teilen des Chips (2) und seines Trägers (16) **durch** Übertragung einer dünnen Folie oder **durch** Aufsprühen von Lack.

12. Elektronische Vorrichtung wie zum Beispiel eine Chipkarte ohne Kontakt mit zumindest einem Chip (2) und einem Träger (16); wobei dieser Chip (2) wenigstens einen Kontaktplot (8) aus schweißbarem Material beinhaltet; wobei der Träger (16) wenigstens eine an den Kontaktplot (8) geschweißte Kommunikationsschnittfläche (14) aufweist; **dadurch gekennzeichnet, dass** die Stärke des Chips (2) zwischen seinen Seiten (2a; 2b) 100 µm nicht übersteigt; der Träger (16) hat wenigstens einen Verbindungsbereich (14a) in Überdicke in der allgemeinen Ebene des Trägers (16), der ohne Aushöhlung oder Ausnehmung ist, um diesen Bereich (14a) anzupassen; und der Chip (2) befindet sich auf dem Verbindungsbereich (14a), damit dieser Bereich sich zwischen dem Chip (2) und seinem Träger (16) befindet.

13. Vorrichtung gemäß Anspruch 12, **dadurch gekennzeichnet, dass** ein entweder Träger (16) in einem mit der Anwendung der Schweißenergie durch die Stärke dieses Trägers (16) kompatiblem Material oder ein Kontaktplot (8) verwendet wird, der die Stärke des Chips (2) durchquert, um auf jeder Seite (2a; 2b) eine Schweißnaht (8a; 8b) aufzuweisen.

14. Vorrichtung gemäß Anspruch 13, **dadurch gekennzeichnet, dass** die Schweißfläche des Kontaktplots (8) deutlich auf derselben Ebene wie die Seite (2b) des Chips (2) gegenüber dem Verbindungsbereich (14a) ist.

15. Vorrichtung gemäß Anspruch 12 bis 14, **dadurch gekennzeichnet, dass** der Chip (2) relativ zur allgemeinen Ebene der Seite (16a) des Trägers (16), auf den er (2) übertragen wurde, eine Überdicke gleich oder unter 50 µm aufweist.

16. Vorrichtung gemäß Anspruch 12 bis 15, **dadurch gekennzeichnet, dass** der Verbindungsbereich (14a) an wenigstens ein Element der Eintritts- und Austrittsschnittstelle (14) mit einem Kontaktlesegerät und / oder einer Kontaktantenne an der Fläche des Trägers (16) angeschlossen ist.

## Claims

1. A method of manufacturing an electronics device comprising at least one chip (2) and a support (16); the method comprising the following steps: a) providing a chip (2) having a thickness of no more than 100 µm, and having at least one contact pad (8) made of a bondable material; b) providing a support (16) having at least one communications interface (14) with at least one interconnect region (14a), the interconnect region (14a) projecting in the form of extra thickness relative to the general plane of the support which is not provided with any cavity or setback for accommodating said region (14a); c) transferring the chip (2) by placing the pad facing the interconnect region so that said region lies between the chip and the support; then d) bonding the contact pad (8) to the corresponding interconnect region of the support (16).

2. A method according to claim 1, **characterized by** steps that firstly make provision (b) either for the support (16) to be made of a material compatible with the bonding technique used, so as to apply the bonding energy through the thickness of said support (16); or for the contact pad (8) to pass through the thickness of the chip (2) so as to have a bonding surface (8a; 8b) on each of its faces (2a; 2b); and secondly, after the chip (2) has been transferred (c) to the surface of the support (16), bond (d) the contact pad (8) to the corresponding interconnect region (14a) of the support (16) by applying bonding energy through the thickness of the support (16) or of the through pad (8).

3. A method according to claim 1 or 2, **characterized in that** the chip (2) is retained by a face (2a; 2b) on a protective substrate (4), and the transfer step c) and/or the bonding step d) is/are performed before a removal step in which said protective substrate (4) is removed.

4. A method according to any one of claims 1 to 3, **characterized in that**: in step a), the thin chip (2) is provided together with a protective substrate (4) having a first face (4b) that retains a set of chips (2); and after the bonding step d), notches (24) are cut in the protective substrate (4) around the chip (2), a point of termination (24a) of the depth of the notch (24) in the protective substrate (4) lying at least under the level of a bottom face (2b) of the chip (2) and, for example, above a face (4a) of said protective substrate (4) that is opposite from its face (4b) facing the chips (2).

5. A method according to claims 3 and 4, **characterized in that**, after the bonding step d), the support (16) with its chip (2) bonded to it is separated from the protective substrate (4), e.g. each bonded chip (2) and its support (16) in the form of a tape is moved away from the protective substrate (4) by generating a tearing or separating force during this removal step.

6. A method according to claim 4 or claim 5, **characterized in that** the protective substrate (4) is retained so as to enable the chip (2) to be removed by being peeled off; e.g., once the notches (24) have been formed, the protective substrate (4) is placed on a holding platform (26) for holding it stationary by mechanical anchoring and/or interposition of an adhesive (26a) such as a film (26a).

7. A method according to any one of claims 4 to 6, **characterized in that** the notches pass through the entire thickness of the protective substrate (4).

8. A method according to any one of claims 1 to 7, **characterized in that** the contact pad (8) passes through the thickness of the chip (2) so as to have a bonding surface (8a; 8b) on each of its faces (2a; 2b), and the chip (2) is bonded to the interconnect region (14a) by applying bonding energy through the thickness of the through pad (8).

9. A method according to claim 8, **characterized in that** the bonding step d) is performed by thermo-compression, ultrasound, or laser beam, through the thickness of the through pad (8).

10. A method according to any one of claims 1 to 7, **characterized in that** the bonding step d) is performed by thermo-compression, ultrasound , or laser beam, through the thickness of the support (16) which is made of a material compatible with the bonding technique used.

11. A method according to any one of claims 1 to 10, **characterized by** a step subsequent to the step d) in which the bonding is performed and optionally in which the protective substrate (4) is removed, which subsequent step consists in depositing a thin protective layer over at least the exposed portions of the chip (2) and of its support (16), by transferring a fine film or by spraying with varnish.

12. An electronics device such as a smart card or a contactless card comprising at least one chip (2) and a support (16); said chip (2) having at least one contact pad (8) made of a bondable material; the support (16) having at least one communications interface (14) bonded to the contact pad (8); said electronics device being **characterized in that** the thickness of the chip (2) between its faces (2a; 2b) does not exceed 100 µm; the support (16) has at least one interconnect region (14a) that projects in the form of extra thickness relative to the general plane of the support (16) which is not provided with any cavity or setback for accommodating said region (14a); and the chip (2) is situated on the interconnect region (14a) so that said region lies between the chip (2) and its support (16).

13. A device according to claim 12, **characterized in that** either a support (16) is used that is made of a material compatible with the bonding energy being applied through the thickness of said support (16), or else a contact pad (8) is used that passes through the thickness of the chip (2) so as to present a bonding surface (8a; 8b) on each of its faces (2a; 2b).

14. A device according to claim 13, **characterized in that** the bonding surface of the contact pad (8) is substantially in the same plane as that face (2b) of the chip (2) which faces the interconnect region (14a).

15. A device according to any one of claims 12 to 14, **characterized in that** the chip (2) has projecting extra thickness equal to or less than 50 µm relative to the general plane of the face (16a) of the support (16) onto which it (2) is transferred.

16. A device according to anyone of claims 12 to 15, **characterized in that** the interconnect region (14a) is connected to at least one interface element (14) providing an inlet and outlet interface with a contact reader and/or an antenna reader, and disposed at the surface of the support (16).
